# EUROPEAN PATENT APPLICATION

(11) **EP 4 841 879 A1**
(43) Date of publication of application: **18.11.2026**
(21) Application number: 25175931.2
(22) Date of filing: 13.05.2025
(51) Int. Cl.: H02M 3/158, H02M 1/00, H02M 1/32, G01R 31/00, G01R 31/01, B60L 3/04, H01H 47/04, H01H 47/22, H02H 3/05

(54) **A BATTERY MANAGEMENT SYSTEM, A METHOD FOR DIAGNOSING A BATTERY MANAGEMENT SYSTEM, A BATTERY SYSTEM INCLUDING THE BATTERY MANAGEMENT SYSTEM AND AN ELECTRIC VEHICLE INCLUDING THE BATTERY SYSTEM**

(71) Applicant: SAMSUNG SDI CO., LTD., Yongin-si, Gyeonggi-do 17084 (KR)
(72) Inventor: Kurcik, Peter, 8505 St. Nikolai im Sausal (AT); Reiter, Harald, 8054 Hitzendorf (AT); Flatscher, Matthias, 8020 Graz (AT)
(74) Representative: Gulde & Partner

(57) **Abstract**

The present disclosure refers to a battery management system (1) including a pyrofuse (10) configured to open a power path of a battery pack, a first boost converter (21) and a second boost converter (22), wherein the first boost converter (21) and the second boost converter (22) have a common input (211, 221) and different outputs (212, 222) connected at an combined output (30), and are each configured to store energy in a charging capacitor (213, 223) of the respective boost converter (21, 22) and to provide the stored energy to fire the pyrofuse (10) when an overcurrent event or short circuit event occurs, and a control unit (40), wherein the control unit (40) is configured to determine an availability of both boost converters (21, 22) based on a determined combined output voltage of the combined output (30) when the boost converters (21, 22) are at least temporarily operated in interleaved operation. The present disclosure further refers to a method for diagnosing a battery management system (1) for firing a pyrofuse (10), a battery system, including the battery management system (1) according to the disclosure, and to an electric vehicle including the battery system according to the disclosure.

## Description

### Field of the Disclosure

Embodiments of the present disclosure relate to a battery management system. The present disclosure also relates to a method for diagnosing a battery management system. The present disclosure also relates to a battery system including the battery management system. The present disclosure also relates to an electric vehicle including the battery system.

### Technological Background

Recently, vehicles for transportation of goods and peoples have been developed that use electric power as a source for motion. Such an electric vehicle is an automobile that is propelled permanently or temporarily by an electric motor using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to provide power for propulsion over sustained periods of time.

Generally, a rechargeable (or secondary) battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. Common battery cell formats, include, for example, cylindrical, prismatic, and pouch.

A battery module is formed of a plurality of battery cells connected together in series or in parallel. That is, the battery module is formed by interconnecting the electrode terminals of the plurality of battery cells depending on a desired amount of power and in order to realize a high-power rechargeable battery.

Battery modules can be constructed either in a block design or in a modular design. In the block design each battery cell is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected together in series to provide a desired voltage.

A battery pack is a set of any number of (for example identical) battery modules or single battery cells. The battery modules, respectively battery cells, may be configured in a series, parallel or a mixture of series and parallel connections to provide the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery cell(s), battery module(s), and battery pack, such as by protecting the batteries from operating outside their safe operating area, monitoring their states, calculating secondary data, reporting that data, controlling its environment, authenticating it and/or balancing it. For example, the BMS may monitor the state of the battery cell as represented by voltage (e.g., a total voltage of the battery pack or battery modules, and/or voltages of individual battery cells), temperature (e.g., an average temperature of the battery pack or battery modules, coolant intake temperature, coolant output temperature, or temperatures of individual battery cells), coolant flow (e.g., flow rate and/or cooling fluid pressure), and current. Additionally, the BMS may calculate values based on the above characteristics or measured values, such as minimum and maximum cell voltage, state of charge (SOC) or depth of discharge (DOD) to indicate the charge level of the battery cell, state of health (SOH; a variously-defined measurement of the remaining capacity of the battery cell as a percent of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be also distributed, with a BMS board installed at each cell, with just a single communication cable between the battery cell and a controller. In yet other examples, the BMS may have a modular construction including a few controllers, each handling a certain number of cells, while communicating between the controllers. Centralized BMSs are most economical, but are least expandable, and are plagued by a multitude of wires. Distributed BMSs are the most expensive, but are simplest to install, and offer the cleanest assembly. Modular BMSs provide a compromise of the features and problems of the other two topologies.

The BMS may protect the battery pack from operating outside its safe operating area. Operation outside the safe operating area may be indicated by overcurrent, over-voltage (during charging), over-temperature, under-temperature, overpressure, and ground fault or leakage current detection. The BMS may prevent the battery from operating outside its safe operating parameter by including an internal switch (e.g., a relay or solid-state device) that opens if the battery is operated outside its safe operating parameters, requesting the devices to which the battery is connected to reduce or even terminate using the battery, and actively controlling the environment, such as through heaters, fans, air conditioning or liquid cooling.

In electric vehicles, the Cell Contacting System (CCS) represents the initial stage of electrical power transmission between the battery cell and consumers or power sources. The number of battery cells in electric vehicles typically ranges from a few hundred to a few thousand. A fully charged lithium-ion single cell typically exhibits a maximum voltage of 4.2 V, with the capacity enabling the delivery of currents in the range of a few amperes up to several 100 amperes. Battery systems for passenger cars operate with voltages between 400 V and 800 V and must be capable of delivering currents of up to 500 A or even more. In order to achieve the requisite voltage and current levels, individual battery cells are connected in parallel and in series.

Therefore, the battery cells are grouped into several functional blocks, which are then connected electrically to form the overall battery system. The aforementioned blocks are then reinforced within a housing structure and are collectively referred to as a battery module. While the battery modules are typically connected in series, the battery cells within the modules are connected in both parallel and series. In the case of cylindrical battery cells, which are relatively small, a number of cells are connected in parallel. In the case of larger battery cells, it is not uncommon for only two to be connected in parallel, or for there to be a pure series connection. It is precisely this electrical interconnection of the battery cells at the module level that the CCS assumes. Consequently, these are available in a multitude of designs and geometries, specifically adapted to the respective battery module.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually include a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further include a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

In electric vehicles, the reliable interruption of an overcurrent event or short circuit is essential to prevent life-threatening situations. Modern systems utilize pyrofuses, which can disconnect the power path of a battery pack significantly faster than conventional melting fuses. Furthermore, the overcurrent trigger threshold can be adjusted with minimal effort, either through software configuration and/or by modifying the circuitry implemented on a printed circuit board (PCB), such as changing a resistor value.

The integration of pyrofuses into an electrical system introduces significant design challenges. Unlike conventional fuses, pyrofuses require precise control mechanisms and detailed system analysis to ensure proper functioning. Engineers must carefully define the triggering criteria, as these determine when and under what conditions the pyrofuse activates. This involves integrating advanced sensing technologies and control circuitry to monitor current, voltage, and system states.

The determination of the availability of a boost converter to ignite a pyrofuse, as well as its capacitance measurement, is critical in battery management systems (BMS). These aspects are particularly significant in ensuring the safety and reliability of energy storage systems, especially under fault conditions.

The capability of a boost converter to perform this task depends on its stored energy, which is primarily determined by the capacitance of its charging capacitor and the voltage level at its output. According to the state of the art, the availability of a boost converter is assessed by monitoring its output voltage and the condition of its capacitor.

### Summary of Invention

The invention is defined by the appended claims. The description that follows is subjected to this limitation. Any disclosure lying outside the scope of the claims is only intended for illustrative as well as comparative purposes.

According to an embodiment, a battery management system is provided, including: a pyrofuse configured to open a power path of a battery pack; a first boost converter and a second boost converter, wherein the first boost converter and the second boost converter have a common input and different outputs connected at an combined output, and are each configured to store energy in a charging capacitor of the respective boost converter and to provide the stored energy to fire the pyrofuse when an overcurrent event or short circuit event occurs; and a control unit, wherein the control unit is configured to determine an availability of both boost converters based on a determined combined output voltage of the combined output when the boost converters are at least temporarily operated in interleaved operation.

According to another embodiment, a method for diagnosing a battery management system for firing a pyrofuse is provided, wherein the method includes the steps of: a) providing a battery management system according to an embodiment; b) operating the boost converters at least temporarily in interleaved operation; c) determining a combined output voltage of the combined output during interleaved operation; d) determining an availability of both boost converters based on the determined combined output voltage of the combined output.

According to another embodiment, a battery system is provided, including: the battery management system according to an embodiment; the battery pack including a housing and at least one battery cell accommodated within the housing.

Yet another embodiment of the present disclosure refers to an electric vehicle including the battery system according to an embodiment.

Further embodiments of the present disclosure could be learned from the dependent claims or the following description.

### Brief Description of the Drawings

Features will become apparent to those of ordinary skill in the art by describing in detail exemplary embodiments with reference to the attached drawings in which:
FIG. 1 illustrates a schematic overview of a first boost converter and second boost converter of a battery management system according to an embodiment.
FIG. 2 illustrates a schematic overview of a battery management system according to an embodiment.
FIG. 3 illustrates a schematic diagram of an operation of a battery management system according to an embodiment.
FIG. 4 illustrates a schematic diagram of an operation of a battery management system according to an embodiment.
FIG. 5 illustrates a schematic diagram of a combined output voltage of a battery management system according to an embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the embodiments and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Expressions such as "at least one of", when preceding a list of elements, modify the entire list of elements and do not modify the individual elements of the list. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may include metallization, e.g. surface metallizations and/or pins, and/or may include conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to one embodiment of the present disclosure, a battery management system includes a pyrofuse configured to open a power path of a battery pack, a first boost converter and a second boost converter, wherein the first boost converter and the second boost converter have a common input and different outputs connected at an combined output, and are each configured to store energy in a charging capacitor of the respective boost converter and to provide the stored energy to fire the pyrofuse when an overcurrent event or short circuit event occurs, and a control unit, wherein the control unit is configured to determine an availability of both boost converters, e. g. for firing the pyrofuse, based on a determined combined output voltage of the combined output when the boost converters are at least temporarily operated in interleaved operation.

Availability may mean that the boost converters are functional, in other words that they can be operated in an active state and/or that they are ready to provide the stored energy to fire the pyrofuse when an overcurrent event or short circuit event occurs. In other words, the availability of a boost converter may refer to its ability to provide the required energy for a specific task under defined operating conditions, for example the ignition of a pyrofuse. It may be determined by the combination of the current output voltage, the capacity of the charging capacitor and the power provided. A boost converter is considered available if its stored energy meets the requirements of a defined load or a defined application, such as pyrofuse ignition.

The power path of a battery pack may refer to an electrical pathway through which power flows from at least one battery cell of the battery pack to a load or downstream systems, such as inverters, motors, or auxiliary devices. This power path typically includes components such as the battery management system (BMS), wiring, connectors, fuses, and circuit protection devices. The pyrofuse plays a critical role within the power path as a safety mechanism designed to disconnect the battery pack in the event of a severe overcurrent or short circuit. It acts as a fast-acting, one-time-use device that interrupts a power flow by physically severing an electrical connection in the power path. This prevents excessive current from damaging the battery, overheating the system, or causing fire hazards. When the pyrofuse is triggered, it effectively isolates the battery pack from the rest of a system, cutting off the power supply to protect both battery cells and downstream components. Its position in the power path ensures that it can interrupt the main current flow quickly and reliably when triggered by the battery management system or an overcurrent detection circuit. Thus, the pyrofuse is an integral part of the power path, ensuring the safe operation of the battery pack under fault conditions.

According to another embodiment, the battery management system may include an energy source that is configured to provide the input voltage to respective input of the boost converters. This energy source serves as the initial power supply for the system and can take various forms, depending on the application. Examples of typical energy sources include a battery, a solar panel, or another DC power source. The energy source delivers the necessary input voltage and current to the boost converter, which then steps up this voltage to provide a higher and regulated output voltage for the connected load (pyrofuse).

A boost converter, also known as a step-up converter, is a DC-DC converter designed to increase an input voltage to a higher output voltage.

The boost converter may consist of a power inductor, e. g. a coil, a switching element such as a transistor, a diode, and a charging capacitor to achieve efficient voltage step-up from a lower input voltage to a higher output voltage. In a switching phase (switching element ON), when the transistor is turned on, it creates a direct path from the input voltage source (energy source) at the input through the inductor to ground. During this phase, the inductor stores energy in the form of a magnetic field as current flows through it. The diode is reverse-biased in this state, preventing current from flowing to the output. In an energy transfer phase (switching element OFF), when the transistor switches off, the sudden interruption of current flow causes the inductor to release its stored energy. The magnetic field collapses, inducing a voltage in the inductor. This voltage adds to the input voltage, creating a higher combined voltage. The diode becomes forward-biased in this phase, allowing the energy from the inductor to flow to the charging capacitor and the load. The charging capacitor smooths the output voltage at the output to ensure a steady supply. The boost converter may operate in a high-frequency switching mode, controlled by a pulse-width modulation (PWM) circuit. The PWM adjusts the on and off times of the switching element to regulate the output voltage, ensuring it remains stable despite variations in input voltage or load conditions.

At the input of the boost converter, the boost converter receives a DC voltage V_{IN} that is typically lower than a desired output voltage Vₒᵤₜ. This input voltage V_{IN} may originate from sources like the batter pack, batteries, solar panels, or other DC power supplies. Along with the voltage Vᵢₙ, an input current Iᵢₙ is drawn based on the power demands of the load and the efficiency of the boost converter.

At the output of the boost converter, the converter provides a higher DC voltage Vₒᵤₜ than the input voltage V_{IN}, as determined by the design and control of the converter. The output current Iₒᵤₜ depends on the power required by the load and is inversely related to the increased voltage, following the principle of energy conservation. The relation between input and output power, considering losses, can be approximated as V_{IN} * I_{IN} ≈ Vₒᵤₜ * Iₒᵤₜ. The output of both boost converters may be connected together to form a combined output, which then forms the connection to the pyrofuse.

The output of both boost converters may be connected together to form a combined output, which then forms the connection to the pyrofuse. In other words, the different outputs may be connected at a combined output.

The charging capacitor refers to a capacitor used in the electronic circuit to temporarily store electrical energy during a charging process. Its primary function is to accumulate charge from an energy source and then release it as needed to smooth, stabilize, or support the circuit's operation. In the context of power electronics and converters, the charging capacitor often plays a critical role in ensuring efficient and stable energy transfer. The charging capacitor stores electrical energy as charge on its plates when connected to an energy source. The amount of charge it can store is determined by its capacitance value and the applied voltage. It helps stabilize voltage levels by providing a steady supply of current during load fluctuations or when the input voltage varies. This is especially important in circuits with high-frequency switching, such as boost converters or inverters. In power conversion circuits, a charging capacitor reduces voltage ripple by smoothing out the fluctuations caused by intermittent energy input or load variations. In dynamic systems, the capacitor can deliver short bursts of energy when the power demand momentarily exceeds the source's supply capability. In the boost converter, the charging capacitor is located at the output stage. It accumulates energy during each switching cycle when the inductor releases its stored energy. This ensures that the output voltage remains stable and continuous, even though the energy from the inductor arrives in pulses. The charging capacitor is thus a key component in various applications, ensuring energy efficiency, voltage stability, and smooth operation of electronic systems.

To ignite the squib of the pyrofuse, a specific amount of energy W_{Stored} is required. This energy can be stored in the charging capacitor with a capacitance C_{BUF} which will be charged up to a specified voltage level V_{BUF} which may be the output voltage Vₒᵤₜ. The energy stored in the charging capacitor can be determined by W_{Stored} = (C_{BUF} * V_{BUF}²) / 2. As can be seen, the use of a boost converter is beneficial to increase the amount of stored energy, by facilitating a high charging voltage, e. g. output voltage, as the charging voltage contributes to the stored energy with the power-of-two. For safety critical applications like the termination of an overcurrent event or a short circuit, a redundant supply or energy storage is required to achieve the safety target.

Internally, the boost converter may employ a switching mechanism, e. g. using a transistor, an inductor and a diode, operating at a high frequency to achieve the voltage step-up. The resulting output voltage Vₒᵤₜ is regulated to remain stable despite variations in the input voltage or load conditions. For example, a boost converter might take an input of 5 V and step it up to 12 V, supplying the required power with a lower output current relative to the input current.

The control unit may be configured to control an at least temporarily interleaved operation of the first boost converter and the second boost converter, wherein only one of the first and second boost converters is in an active state alternately during interleaved operation.

When the boost converter is described as being active or being in an active state, it may mean that the converter is operational and actively processing electrical energy to increase the input voltage V_{IN} to a higher output Vₒᵤₜ as described before (is alternately in the switching phase and the energy transfer phase). This indicates that the converter is in a working state, where energy is continuously drawn from the energy source through the input of the boost converter and delivered to the output or load. The internal switching mechanism, e. g. a transistor, an inductor and a diode, are functioning as intended. The transistor switches on and off at high frequencies, creating the necessary conditions for the inductor and capacitors within the circuit to store and transfer energy efficiently. This process enables the boost converter to step up the voltage while regulating the output to match the desired level. Additionally, being active implies that the boost converter's control system is engaged, monitoring the input and output conditions to ensure stable and accurate voltage regulation. This ensures that the boost converter adapts to variations in input voltage or load demand while maintaining optimal performance.

When a boost converter is described as being inactive or being in an inactive state, it means that the converter is not operational and is not actively processing or transferring energy to step up the input voltage to a higher output voltage (is not alternately in the switching phase and the energy transfer phase). In this state, the internal components, such as the transistor, inductor, and diode, are not engaged in their switching and energy transfer functions.

Thus, during interleaved operation, only one of the first and second boost converters is active and the other one is inactive, so that the first and second boost converters are not active at the same time. Both boost converters can still be inactive at the same time. The gist of the disclosure is to use two redundant boost converters to maintain an energy reservoir required to fire a pyrofuse, without introducing large power demands. Thereby, to minimize electromagnetic emissions and to lower the ripple voltage on the common input supply, the two boost converters are operated in an interleave-mode at least temporarily. During interleave-mode, only one boost converter is active and switching.

The present disclosure eliminates the need for two separate ADCs. For systems offering a limited number of ADCs, the availability of the boost converters can be determined by the combined output voltage, which can be used to determine whether both boost converters can be operated properly or whether there are deviations from a normal or typical course that indicate at least one faulty boost converter. This approach offers more efficient use of existing ADC resources, saves costs and reduces circuit complexity, while at the same time reliably determining the status of the capacitors and the availability of the boost converters.

In other words, the charging capacitors of the two boost converters may be connected in such a way that their combined voltage can be observed as a single waveform. Instead of measuring both voltages individually, the combined voltage can be recorded using a suitable circuit. This represents the total voltage of the two charging capacitors. The waveform shows characteristic changes depending on whether the boost converters are in ON-Mode or OFF-Mode. When a boost converter is in ON-Mode, it actively charges its charging capacitor. This leads to an increase in voltage, which is reflected in the combined voltage. If the boost converter is in OFF-Mode, the charging capacitor discharges. This results in a characteristic voltage drop. By analyzing the combined output voltage, it is possible to determine whether both boost converters are working correctly and are available. In this way, the functionality of the boost converter can be checked without the need for separate ADCs for both capacitor voltages.

According to one embodiment, the battery management system may include a first switching element for enabling and disabling the first boost converter and a second switching element for enabling and disabling the second boost converter, and the control unit may be configured to control the first switching element and the second switching element to change an operating state of the first and the second boost converter between an active state, or in other words being active, and an inactive state, or in other words being inactive. In other words, to perform interleaved operation, the battery management system may include a first switching element configured to activate and deactivate the first boost converter and may include a second switching element configured to activate and deactivate the second boost converter. The control unit may be configured to control the first and second switching element to activate and deactivate the first and second boost converter.

According to another embodiment, the first and second boost converters may each include a regulation path configured to adjust an output voltage at the respective output. Accordingly, in addition to the switching frequency of the switching mechanism of a boost converter, the charging current for the charging capacitor can be changed. Each regulation path may include a regulation resistor to adjust the output voltage at the output. This regulation resistors can limit the current trough the switching element of the boost converters and consequently will also contribute to the maximum current which is available on the corresponding outputs. This represents a type of sensing and this kind of sensing (regulation resistors) can be used to protect the switching elements. Nevertheless, the output current of the respective boost converter depends on the load connected to the output, and of course on the output voltage of the regulator.

According to another embodiment, the battery management system may include a first diode connected to the output of the first boost converter, e. g. before the combined output, and a second diode connected to the output of the second boost converter, e. g. before the combined output. In other words, the first and second boost converters may be separated by respective first and second diodes to prevent reverse currents and ensure stable operation. Without these diodes, slight voltage differences between the converters could might cause unwanted current circulation, leading to inefficiencies or potential malfunctions. Additionally, if one boost converter fails, the respective diode prevents it from interfering with the functioning boost converter, ensuring that the pyrofuse still receives the necessary voltage for activation. The diodes also enhance fault isolation, preventing a shortcircuited converter from affecting the entire system. This design ensures a stable and reliable power supply, which is critical for safety applications such as battery management in electric vehicles.

According to another embodiment, the control unit may be configured to control the first and second boost converters based on hysteresis during interleaved operation. In other words, the control unit may be configured to control the first and second boost converters based on hysteresis that maintains the respective output voltage at the output within a predefined range by activating a switching element of the first boost converter, e. g. a transistor, and a switching element of the second boost converter, e. g. a transistor, when the corresponding output voltage reaches or drops below a lower limit, and deactivating the switching element of the first boost converter and the switching element of the second boost converter when the corresponding output voltage reaches or exceeds an upper limit. In other words, the boost converters are activated when they fall below a lower limit and deactivated when they reach or exceed an upper limit. The hysteresis control offers several advantages in regulation systems, particularly in power electronics, energy management, and switching regulators. Its benefits stem from its simple, robust, and responsive behavior. One of the key advantages is its fast response time, as the hysteresis control reacts immediately to changes in input variables, such as the output voltage. Unlike PID or linear controllers, it does not involve delays caused by integrators or complex algorithms. Additionally, the implementation is straightforward, relying on a simple comparison of actual and target values within predefined switching limits or thresholds (hysteresis bandwidth). This simplicity reduces the complexity of both hardware and software implementations. The method also provides a stable switching frequency, maintaining operation within the defined hysteresis band and making it resistant to noise and minor disturbances. This leads to greater robustness in noisy or unstable environments. Moreover, it ensures precise control of the output variable, such as the voltage, as the system only switches when the boundaries of the hysteresis band are reached or exceeded. Another advantage is the prevention of overshooting or undershooting, as the controller avoids unnecessary switching, reducing losses and keeping the output variable stable. Furthermore, hysteresis control ensures high efficiency, particularly in power electronics, by minimizing switching efforts and operating in an optimal range for switching losses. Overall, hysteresis control combines simplicity, stability, and efficiency, making it well-suited for applications like DC-DC converters.

According to another embodiment, the control unit may be configured to activate, or in other words perform, the interleaved operation after an upper limit of the hysteresis, e. g. a desired output voltage, has been reached by at least one boost converter after a start-up phase of the boost converters.

The start-up phase of a boost converter may be the initial period of operation when the system provides the current and energy required to meet specific demands, such as firing a pyrofuse, and stabilizing the output voltage. A high current is needed if the charging capacitor has to be charged fast. This is based on an availability requirement. If there are no time restrictions, this charging process can take longer, which means with low current demand. Overall, the energy and the resulting current to fire the pyrofuse, is provided by the charging capacitor. This capacitor will be initially charged (start-up) over a longer time span (low boost converter currents) or over a shorter time span (higher boost converter currents). This phase begins when the boost converter is powered on or reactivated and continues until all predetermined start-up conditions are satisfied, transitioning into a run-time phase. During the start-up phase, the system must supply a high current to ensure the necessary energy is delivered for critical operations. For example, firing a pyrofuse requires a rapid and significant energy discharge to trigger its thermal reaction reliably. In addition, the boost converter must rapidly charge the charging capacitor to store enough energy for steady operation and bring the output voltage to the desired range. This phase is characterized by transient, high-power conditions that place greater demands on the converter's input. It is also the period during which electromagnetic emissions and ripple on the input voltage are at their highest due to the increased current flow and dynamic adjustments. The boost converter's design must account for these effects to maintain system stability and protect connected components. The start-up phase ends once the output voltage is stabilized, the charging capacitor is adequately charged, for example the stored energy is in an interval of about ± 10% or ± 5% of a predetermined amount of stored energy, and the system no longer requires high current to meet transient demands. At this point, the converter transitions into the run-time phase, where current requirements decrease, and steady-state operation begins. The start-up phase of the boost converter may refer to an initial operating period during which the boost converter transitions from an off state to its normal working mode. This phase is carefully managed to ensure a safe and stable start-up, avoiding damage to components or the load due to sudden current or voltage spikes. During the start-up phase, energy is gradually stored in the inductor and charging capacitor to prevent abrupt surges. In this process, the switching transistor is controlled with a progressively increasing pulse-width modulation (PWM) signal, allowing the converter to build up voltage in a controlled manner. Once the output voltage reaches the target level, the boost converters transition into the regular operation mode, where the voltage is dynamically regulated to remain stable. This carefully controlled start-up phase is critical for protecting components from inrush currents, maintaining stability at the power source, and ensuring a smooth transition to normal operation. It is particularly important in boost converters with large output capacitance or when powering sensitive loads, ensuring reliability and longevity of the system. Hysteresis is used to keep the output voltage within a defined range. Instead of switching the converter on and off exactly at a limit value, a buffer range is introduced. For example, with a target voltage of 12 V, the converter could switch on when the voltage falls below a lower limit of 11.8 V and switch off when it exceeds an upper limit of 12.2 V. This prevents excessive switching and ensures smooth operation. Accordingly, the hysteresis comprises a lower limit and an upper limit, which form a range within which the target output voltage lies.

According to another embodiment, the battery management system may include a first pre-charge path configured for limiting an inrush current of the first boost converter during a pre-charge phase and a second pre-charge path configured for limiting an inrush current of the second boost converter during the pre-charge phase. At the pre-charge phase the first switching element and second switching element may be non-conductive or in others the boost converters are disabled until the output voltage Vₒᵤₜ is close to V_{IN}. This avoids the triggering of a current-limiter circuits which might protect the V_{IN} supply rail. The pre-charge path may be disabled after start-up and the boost converters may be enabled.

The start-up phase may include the pre-charge phase. Start or begin of the pre-charge phase and of the start-up phase may be the same. End of the pre-charge phase may be before an end of the start-up phase.

According to another embodiment, the battery management system may include a first soft-start path configured for mitigating an inrush current of the first boost converter during a soft-start phase and a second soft-start path configured for mitigating an inrush current of the second boost converter during the soft-start phase. In other words, for example after finishing the pre-charge phase, a softer/shorter switching may be configured, for example by a capacitor, and for example at the beginning of a boost-phase. This feature further helps to mitigate high inrush currents.

The start-up phase may include the soft-start phase. Start or begin of the soft-start phase may be after the pre-charge phase. End of the soft-start phase may be before an end of the start-up phase.

According to another embodiment, the battery management system may include a first current-limiting path configured for limiting an output current of the first boost converter during a run-time phase and a second current-limiting path configured for limiting an output current of the second boost converter during a run-time phase. During the start-up phase, a high current is required to provide the necessary energy for firing the pyrofuse and to meet system availability requirements. In the event that the boost converter cannot provide sufficient current to fire the pyrofuse during the start-up phase, the capacitor of the corresponding boost converter is charged as quickly as possible due to the possible high current during the start-up phase. This current can then be reduced during the run-time phase. The pyrofuse relies on a rapid thermal reaction, which demands a significant amount of energy to activate reliably. Once the system transitions to the run-time phase, the current demand decreases. During this phase, the system only needs to maintain the energy stored in the charging capacitor and keep the output voltage within a specific range. To optimize performance during run-time, the boost converters employ a current limit set by the current-limiting feature. This current limitation reduces electromagnetic emissions (EMI) by minimizing high-current spikes that could otherwise cause interference. Additionally, it lowers the ripple voltage on the input, which helps stabilize the system and enhances efficiency. By distinguishing between the high current requirements during start-up and the reduced current demand during run-time, the system achieves reliable operation while mitigating unwanted electrical disturbances. To further enhance safety, the current is limited during the start-up phase to avoid overcurrent conditions that could harm the switch, inductor, or power source. For example, by a combination of the current limiting paths and the regulations paths, the current can be limited in general by (during all operating phases) by the regulation paths. Furthermore, the current limiting paths can be used to decrease the current limit during the run-time phase, so that such an embodiment allows higher currents during start-up.

The run-time phase of a boost converter begins after the start-up phase is successfully completed and continues as long as the converter operates under normal conditions. This phase starts when specific prerequisites are met: the start-up tasks, such as firing the pyrofuse if required, have been accomplished, the output voltage has reached the desired range and stabilized, and the charging capacitor has been sufficiently charged. During this phase, the boost converter no longer operates under transient high-load conditions. The run-rime phase is characterized by a reduced current demand, as the primary objective is to maintain the output voltage within a defined range and ensure that the energy stored in the charging capacitor is sufficient for system needs. It represents the steady-state operation of the system, where the load is predictable, and the boost converter operates efficiently. This phase lasts until the system is shut down, a fault occurs, or a new high-load condition (such as the reactivation of the pyrofuse) triggers a return to the start-up phase. Unlike the start-up phase, which requires a high current to meet initial energy demands, the run-rime phase focuses on sustaining system stability with a lower, consistent current requirement. It ensures continuous and efficient energy supply with minimal electrical disturbances and high stability.

According to another embodiment, the control unit may be configured to determine the availability of both boost converters based on a characteristic waveform of the determined combined output voltage. In other words, the characteristic waveform of the determined combined output voltage may have a curve that differs from a typical predefined waveform of two available, i.e. error-free, boost converters and the control unit may be configured to determine the availability of both boost converters based on the deviation between the determined combined output voltage and a predetermined combined output voltage. In other words, the control unit may be configured to determine the availability of both boost converters based on the deviation between a curve of the determined combined output voltage and the typical predefined waveform of a predetermined combined output voltage. This makes it possible to recognize that at least one boost converter is behaving abnormally based on the deviation from a normally occurring course. In other words, the combined output voltage determined may be evaluated with regard to characteristic curves or deviations. Characteristic changes in state or time curves can be identified, which provide information about the operating status or quality of individual components. The determined combined output voltage is compared with predefined reference values or ranges. This allows deviations to be identified that may indicate operating or component faults. In this embodiment, the availability of both boost converters is determined by analyzing a characteristic waveform of the combined output voltage. This approach leverages the dynamic behavior and temporal variations in the voltage to assess the operational state of the boost converters. The combined output voltage is influenced by the performance of both boost converters, including their capacitors and switching circuits. During operation or discharge, the control unit monitors the waveform of this voltage. Key characteristics, such as the rate of voltage decay, oscillations, or steady-state levels, provide insights into the energy storage capacity and functional status of each boost converter. For example, if one of the boost converters is inactive or its capacitor is degraded, the characteristic waveform may exhibit faster voltage decay or reduced amplitude. By comparing the observed waveform to expected patterns under normal operation, the control unit can determine whether both boost converters are sufficiently available to deliver the required energy for tasks such as igniting a pyrofuse. This method provides a reliable and non-intrusive way to evaluate the availability of the system in real time.

According to another embodiment, the control unit may be configured to detect that at least one of the boost converters is permanently in an inactive state based on a threshold value of the determined combined output voltage. Because at least one of the boost converters is permanently inactive, its charging capacitor is not charged or its voltage may drop, both of which have an effect on the combined output voltage. A threshold value can also take tolerances into account. The behavior of the combined output voltage relative to the threshold value, such as approaching or moving away from the threshold value or falling below or exceeding it, then allows reliable conclusions to be drawn about the state of at least one boost converter.

The threshold value may be between an upper limit and a lower limit of the hysteresis.

According to another embodiment, the control unit may be configured to detect that at least one of the boost converters is permanently in an inactive state by monitoring a crossing of the determined combined output voltage of the threshold value, either from below to above or above to below, with distinct timing patterns depending on whether both boost converters are operating in interleaved mode or whether one boost converter is permanently inactive. The algorithm to detect that one boost converter is permanently off uses a threshold on the combined output voltage. The evaluation can use the fact that this threshold is crossed from below to above or above to below with different timings for the case that both boost converters are operating in interleaved mode and are working as intended or that one boost converter is permanently of (fault case).

According to another embodiment, the battery management system may further include a combined analog-to-digital converter, ADC, connected to the combined output for determining the combined output voltage. The battery management system may include a redundant analog-to-digital converter.

According to another embodiment, the battery management system may further include a combined diagnostic load, e.g. a combined diagnostic load resistor, connected in parallel with the boost converters at the combined output, and wherein the control unit may be configured to determine a total capacitance of the boost converters based on a measured voltage decay (or in other words drop) of a voltage across the combined diagnostic load and a known resistance value of the combined diagnostic load during a respective discharging of both boost converters. In other words, the control unit may be configured to determine a capacitance of the first boost converter and a capacitance of the second boost converter based on a measured voltage decay (or in other words drop) of a voltage across the combined diagnostic load and a known resistance value of the combined diagnostic load during a discharging of the first boost converter and based on a measured voltage decay (or in other words drop) of a voltage across the combined diagnostic load and a known resistance value of the combined diagnostic load during a discharging of the second boost converter. The battery management system may include a redundant combined diagnostic load. In other words, the interleaved operation may be temporarily paused (or both boost converters may be in an inactive state of the interleaved operation) and both boost converters may be discharged one after the other in order to determine their respective capacitances and thus the total capacitance. In other words, first one of the two boost converters may be discharged and then the other. In a parallel circuit, the total capacitance is simply the sum of all individual capacitances. This is because, in a parallel configuration, each capacitor experiences the same voltage, and their charge storage capabilities add up. Accordingly, the total capacitance results from the sum of the respective capacities of both boost converters. In other words, the control unit may be configured to determine the total capacitance of the boost converters based on the sum of the capacitance of the first boost converter and the capacitance of the second boost converter. The interleaved operation may then be resumed and continued after determining of the total capacitance. Determining the total capacitance of the charging capacitors in the boost converter provides important information that is important for reliable operation as well as for diagnosing and optimizing the system. Over time, capacitors lose capacitance due to ageing processes (e.g. thermal or electrical stress). A measured deviation of the total capacitance from its target value indicates wear or incipient defects. The condition of the capacitors can be monitored during operation in order to plan maintenance or replacement in good time. A sudden loss of capacitance may indicate a defective capacitor, for example due to internal short circuits, dielectric layer failures or thermal overload. The capacitance of the charging capacitors influences the dynamic response of the boost converter, e.g. in the event of load changes or voltage fluctuations. Precise knowledge of the capacitance makes it possible to adapt the control unit accordingly. Optimized control algorithms are possible to minimize voltage fluctuations and improve stability. The soft-start phase can be made more efficient if the exact capacitance is known. This prevents excessive inrush currents and enables improved soft-start process for a safe and controlled system start. The capacitance C of each of the two capacitors of the respective boost converter may be determined by measuring the voltage curve V(t) over time during discharge from an initial voltage V₀ of the respective capacitor. The voltage across the resistance value R_{L} of the load decreases according to the discharge equation of the charging capacitors V(t) = V₀ * e^{-t/(R}_{L}*^{C)}. Both boost converters are switched off simultaneously so that their capacitors are discharged one after the other to the combined diagnostic load. The discharge takes place via the combined diagnostic load, which is connected to the respective capacitor. The voltage V(t) across the combined diagnostic load is measured continuously (e. g. with the combined ADC). The time t required for a voltage drop from V₀ to a lower voltage is recorded. The capacitance C is calculated from the time constant τ, which is determined by the voltage exponential function τ = R_{L} * C, with C = τ /R_{L}. The time constant τ is determined from the measured voltage curve τ = -t / In (V(t)/V₀).

According to another embodiment, the control unit may be configured to determine the total capacitance or the capacitances of both boost converters before contactors of the battery management system or of the battery pack are closed. Contactors are high-power electromechanical switches that control the connection and disconnection of a battery from the electrical system. Used in electric vehicles (EVs), energy storage systems (ESS), and industrial battery applications, contactors enable or disable the battery's connection to the motor, inverter, or charger. One of their key functions is to provide a controlled switching mechanism for high-voltage and high-current circuits. They prevent dangerous overcurrent conditions and electrical faults by quickly disconnecting the battery in case of a malfunction. In electric vehicles, for example, contactors act as a safety measure by isolating the battery pack in the event of a crash, thereby preventing electrical hazards. The contactors may be integrated into the battery management system (BMS) to ensure safe operation during charging and discharging cycles. The BMS may be configured to monitor the condition of the battery pack and control the contactors to ensure safe and efficient use of the battery pack. The contactors also allow for emergency shutdown in case of thermal or electrical anomalies, preventing battery damage and enhancing overall system reliability. With the increasing adoption of battery-powered technologies, contactors continue to play a vital role in ensuring the efficiency and safety of modern energy storage and power distribution systems. The determination after the contactors are closed helps to not affect the availability for firing the pyrofuse. For safety reasons, both boost converters shall be kept connected to the combined output when the contactors are closed. Nevertheless, by determining the individual capacitances before the contactors are closed, and an online monitoring of the combined voltage information if the required energy is above a certain required threshold can be obtained. The approach to determine the availability of both boost converters based on a characteristic waveform of the determined combined output voltage may be used to check if both capacitors are charged (are available). This gives information if both capacitors are contributing to the total capacitance and storing energy. This provides an online feedback of the available energy. As the term run-time phase was used in this document, it refers to the state of operation of the boost converter after finishing the start-up, and gives no information regarding the state of contactors (open or closed).

The combined analog-to-digital converter (ADC) may be connected to the combined diagnostic load to measure or for determining the voltage across the combined diagnostic load, for example by additionally using either a voltage divider or a current shunt resistor. If the voltage range to be measured is within the permissible range of the ADC input, the voltage may be applied directly to the ADC input. A voltage divider may be used to reduce higher voltages to the permissible range of the ADC. A series resistor may be used for input protection and current limiting if there is a sudden voltage change.

The control unit may be configured to disconnect the boost converters sequentially from the combined output, discharge both charging capacitors of the boost converters sequentially through the combined diagnostic load, measure a respective voltage across the combined diagnostic load during the respective discharge, and to calculate the total capacitance of the charging capacitors based on a respective measured voltage decay of the voltage across the combined diagnostic load and a known resistance value of the load. In other words, the control unit may be configured to first disconnect one of the boost converters from the combined output, discharge the charging capacitor of the other still connected boost converter through the combined diagnostic load, measure a voltage across the combined diagnostic load during this discharge, and to calculate the capacitance of the charging capacitor of the other still connected boost converter based on a measured voltage decay of the voltage across the combined diagnostic load and a known resistance value of the load. Further, the control unit may be configured to reconnect the one of the boost converters to the combined output and to disconnect afterwards the other of the boost converters from the combined output, discharge the charging capacitor of the one reconnected boost converter through the combined diagnostic load, measure a voltage across the combined diagnostic load during the discharge, and to calculate the capacitance of the charging capacitor of the one reconnected boost converter based on a measured voltage decay of the voltage across the combined diagnostic load and a known resistance value of the load. Further, the control unit may be configured to calculate the total capacitance of the charging capacitors based on a sum of both capacitances of the charging capacitors of both boost converters. The control unit may be configured to reconnect both boost converters after finished determination of the total capacitance.

According to another embodiment, the control unit may be configured to determine the total capacitance of the boost converters during a run-time phase of the boost converters. In other words, the control unit may be configured to determine the total capacitance of the boost converters after completion of the start-up phase. Discharging can take place without impairing the ability to ignite the pyrofuse, as both boost converters are sufficiently charged and have sufficient stored energy. This approach allows real-time monitoring of the energy storage capacity without interrupting the operation of the system. This real-time determination is particularly useful for ensuring that the boost converters have sufficient energy storage capacity to perform critical tasks, like igniting a pyrofuse, even under varying operational conditions. It also enables early detection of capacitor degradation, enhancing the overall reliability and safety of the system.

According to another embodiment, the battery management system may further include a first diagnostic load, e.g. a first diagnostic load resistor, connected to the output of the first boost converter, and wherein the control unit may be configured to determine a capacitance of the first boost converter based on a measured voltage decay (or in other words drop) of a voltage across the first diagnostic load and a known resistance value of the first diagnostic load during a discharging of the first boost converter. Further, the battery management system may further include a second diagnostic load, e.g. a second diagnostic load resistor, connected to the output of the second boost converter, and wherein the control unit may be configured to determine a capacitance of the second boost converter based on a measured voltage decay (or in other words drop) of a voltage across the second diagnostic load and a known resistance value of the first diagnostic load during a discharging of the first boost converter.

According to some embodiments, the battery management system may further include a first analog-to-digital converter connected to the output of the first boost converter for determining the voltage across the first diagnostic load. The battery management system may include a redundant first analog-to-digital converter. Further, the battery management system may include a second analog-to-digital converter connected to the output of the second boost converter for determining the voltage across the second diagnostic load. The battery management system may include a redundant second analog-to-digital converter. The first and second analog-to-digital converters (ADC) may be connected to the respective diagnostic loads to measure or for determining the voltage across the respective diagnostic load, for example by additionally using either a voltage divider or a current shunt resistor. If the voltage range to be measured is within the permissible range of the respective ADC input, the voltage may be applied directly to the respective ADC input. A voltage divider may be used to reduce higher voltages to the permissible range of the respective ADC. A series resistor may be used for input protection and current limiting if there is a sudden voltage change. During operation in the active state, the boost converters are alternately in the switching phase and the energy transfer phase, i.e. in the off-state the switching transistor is disabled and no current flows through the inductor. During the inactive state, a defined load resistance of each boost converter enables a controlled discharge of the charging capacitor. This load resistance represents a known load that is used to calculate the capacitance of the charging capacitors of the respective boost converter. To determine the capacitance during operation, e. g. when contactors are closed, the respective analog-to-digital converter (ADC) is therefore provided for each boost converter. This measures the voltage values on the respective charging capacitor. The capacitance of the respective charging capacitor can be calculated using the known resistance and the measured voltage change. The battery management system may include a redundant first and second diagnostic load. Here it has to be mentioned, that by analyzing the individual voltages directly at the output of the boost converter it would be possible to perform an online diagnostic (e. g. when contactors are closed). Here, the individual capacitances are monitored (the total would be the sum). Here, each booster needs a diagnostic load connected directly to its output. The combined output load is not needed. For example, if one of the two boost converters is in inactive state during interleaved operation, its capacity can be determined. The discharge-time is also significantly long enough to perform the determination.

According to another embodiment, the control unit may be configured to determine a total stored energy in both boost converters based on the determined combined output voltage and the total capacitance. This makes it possible to determine whether sufficient energy can be provided by the overall system to ignite the pyrofuse, even in the event that a boost converter is not or not sufficiently available. In other words, the control unit may be configured to determine the total stored energy in both boost converters by utilizing the measured combined output voltage and the calculated total capacitance. This approach enables an accurate assessment of the energy available in the system at any given time.

According to another embodiment, each boost converter may be connected to the combined diagnostic load through a separate switching element, e. g. a MOSFET switch or relay, and wherein the control unit may be configured to open one of the separate switching elements to disconnect the corresponding boost converter from the combined diagnostic load, and wherein the control unit may be further configured to determine the capacitance of the remaining connected boost converter based on a measured voltage decay (or in other words drop) across the combined diagnostic load and the known resistance value of the combined diagnostic load during a discharging of the remaining connected boost converter. In other words, each boost converter is connected to the combined diagnostic load via a separate switching element, such as a MOSFET switch or a relay. The control unit may be configured to open one of these switching elements to disconnect the corresponding boost converter from the combined diagnostic load. By doing so, the remaining connected boost converter is isolated for individual analysis. The control unit then determines the capacitance of the remaining connected boost converter by monitoring the voltage decay across the combined diagnostic load during the discharge process. The known resistance value of the combined diagnostic load is used in conjunction with the measured voltage decay to calculate the capacitance. This calculation relies on the time constant of the voltage decay, which is a function of the capacitance and the resistance. This approach enables the control unit to individually evaluate the capacitance of each boost converter without requiring additional diagnostic hardware. It ensures precise monitoring of the energy storage components, allows early detection of potential degradation or failures, and contributes to the overall reliability and safety of the system. This makes it possible to determine the individual capacities of the respective charging capacitors of both boost converters using only one combined ADC.

According to one embodiment, a method for diagnosing a battery management system for firing a pyrofuse includes a step of providing a battery management system according to an embodiment. Further, the boost converters are at least temporarily operated in interleaved operation and a combined output voltage of the combined output is determined during interleaved operation. The method includes a step of determining an availability of both boost converter, e. g. for firing the pyrofuse, based on the determined combined output voltage of the combined output.

According to another embodiment, the step of determining an availability of both boost converters may include a step of detecting that at least one of the boost converters is permanently in an inactive state based on a threshold value of the determined combined output voltage.

According to another embodiment, the step of detecting that at least one of the boost converters is permanently in an inactive state may include a step of monitoring a crossing of the combined output voltage of the threshold value, either from below to above or above to below, with distinct timing patterns depending on whether both boost converters are operating in interleaved mode or whether one boost converter is permanently inactive.

According to another embodiment, the method may further include a step of determining a total capacitance of the boost converters based on a measured voltage decay (or in other words drop) of a voltage across a combined diagnostic load connected in parallel with the boost converters at the combined output and a known resistance value of the combined diagnostic load during a respective discharging of both boost converters.

According to another embodiment, the step of determining a total capacitance of the boost converters may be performed before contactors of the battery management system or of the battery pack are closed.

Another embodiment of the present disclosure refers to a battery system, including the battery management system according to the disclosure, and the battery pack including a housing and at least one battery cell accommodated within the housing.

Yet another embodiment of the present disclosure refers to an electric vehicle. The electric vehicle includes the battery system according to the disclosure.

Yet another embodiment of the present disclosure refers to a method for operating a battery management system according to the disclosure. The method includes to control an at least temporarily interleaved operation of the first boost converter and the second boost converter, wherein only one of the first and second boost converters is in an active state alternately during interleaved operation.

The described advantages of the battery management system also apply to the method for operating the battery management system. The corresponding embodiments of the method may include, among other aspects, the embodiments and its configurations, e. g. specific configurations and functionalities, of the control unit. The interleaving method involves coordinated phase-shifted operation of multiple boost converter branches to reduce ripple currents and improve system efficiency, directly reflecting the logic control provided by the interleaving module.

### Specific Embodiments

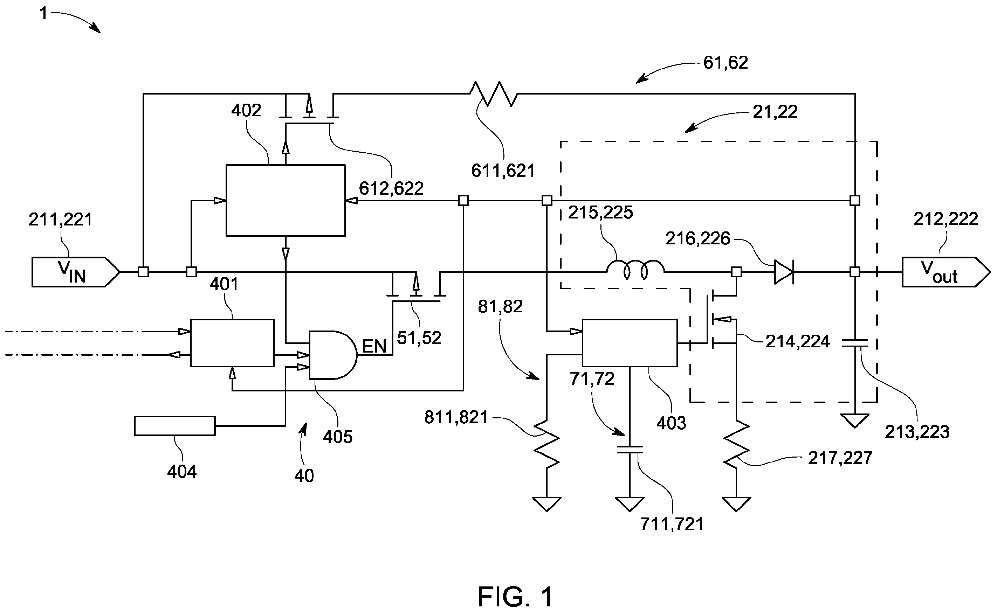

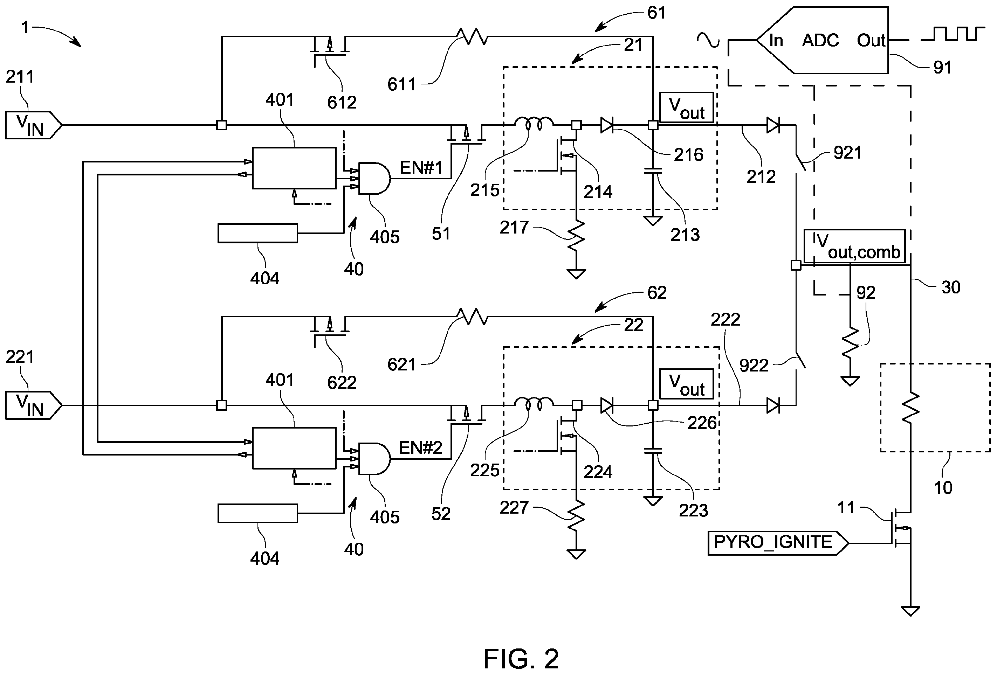

FIG. 1 is a schematic overview illustrating a boost converter 21, 22 of a battery management system 1 according to an embodiment. The battery management system 1 includes a pyrofuse (see FIG. 2) configured to open a power path of a battery pack, a first boost converter 21 and a second boost converter 22, wherein the first boost converter 21 and the second boost converter 22 have a common input 211, 221 and different outputs 212, 222 and are each configured to store energy in a charging capacitor 213, 223 of the respective boost converter 21, 22 and to provide the stored energy to fire the profuse when an overcurrent event or short circuit event occurs. The battery management system 1 further includes a control unit 40, wherein the control unit 40 is configured to control an at least temporarily interleaved operation of the first boost converter 21 and the second boost converter 22, wherein only one of the first and second boost converters 21, 22 is an active state alternately during interleaved operation. Further, the control unit 40 is configured to determine an availability of both boost converters based on a determined combined output voltage of the combined output 30 when the boost converters 21, 22 are at least temporarily operated in interleaved operation.

A connection between the control unit 40 and components is designed differently depending on the system 1 and is used for control, monitoring and communication. Preferably, the control unit 40 performs central control and regulation tasks by sending signals to the corresponding component in order to adjust or control its operation. Alternatively, one or more of the present components is also equipped with a separate, independent decentralized control unit that is directly adapted to specific requirements.

The control unit 40 includes a first decentralized logic 401 connected to the first and second switching elements 51, 52 and configured to manage the change between the active state and the inactive state of both boost converters 21, 22 based on interleaved operation.

Only one boost converter is explicitly shown. In the present embodiment, the first and second boost converter 21, 22 are nevertheless shown, since they are identically constructed according to this embodiment. However, they may differ from each other in optional features.

Therefore, input and output signals of the first decentralized logic 401 are only partially illustrated. The first decentralized logic 401 of the first boost converter 21 is connected to the corresponding first decentralized logic 401 of the second boost converter 22 (see FIG. 2 for the connection). The input signal of first decentralized logic 401 in the first boost converter 21 includes, for example, information about the operational status of the second boost converter 22 and thus corresponds to the output signal of first decentralized logic 401 in the second boost converter 22. Conversely, the output signal of first decentralized logic 401 in the first boost converter 21 contains information about the operational status of the first boost converter 21 and serves as the input signal for first decentralized logic 401 in the second boost converter 22. The respective information about the operational status is obtained by an additional input signal of each of the first decentralized logics 401. This additional input signal is obtained using a connection to the respective output 212, 222. In this way, the first boost converter 21 and the second boost converter 22 exchange information about their respective statuses, enabling each logic unit to generate an additional output signal for an AND-gate 405 connected to the first, second and fourth decentralized logic 401, 402, 404 receiving a first input (in other words, the additional output signal of the respective first decentralized logic 401) for a signal based on the interleaved operation, a second input for a signal based on first and second pre-charge paths 61, 62 and a third input for a signal based on occurring of an overcurrent event and providing a control signal EN for the first and second switching elements 51, 52.

The boost converter 21, 22 consist of a power inductor 215, 225, e. g. a coil, a switching element 214, 224 such as a transistor, a diode 216, 226, and a charging capacitor 213, 223 to achieve efficient voltage step-up from a lower input voltage V_{IN} to a higher output voltage Vₒᵤₜ.

At the input 211, 212 of the boost converter 21, 22, the boost converter 21, 22 receives a DC voltage V_{IN} that is typically lower than a desired output voltage Vₒᵤₜ. At the output 212, 222 of the boost converter 21, 22, the boost converter 21, 22 provides a higher DC voltage Vₒᵤₜ than the input voltage V_{IN}, as determined by the design and control of the boost converter 21, 22. The output current Iₒᵤₜ depends on the power required by the load and is inversely related to the increased voltage, following the principle of energy conservation.

The output 212, 222 of both boost converters are connected together to form a combined output 30 (see FIG. 2), which then forms the connection to the pyrofuse.

The battery management system 1 includes a first switching element 51 for enabling and disabling the first boost converter 21 and a second switching element 52 for enabling and disabling the second boost converter 22, and the control unit 40 is configured to control the first switching element 51 and the second switching element 52 to change a state of the first and the second boost converter 21, 22 between being active, or in other words the active state, and being inactive, or in other words an inactive state. The first and second switching elements 51, 52 are a metal-oxide-semiconductor field-effect transistor, MOSFET.

The first and second boost converters 21, 22 each include a regulation path to adjust the output voltage at the output 212, 222. Accordingly, in addition to the switching frequency of the switching mechanism of a boost converter, the charging current for the charging capacitor 213, 223 can be changed. The regulation path each includes a regulation resistor 217, 227 to indirectly adjust the output current at the output 212, 222. This regulation resistors 217, 227 is limiting the current trough the switching element of the boost converters 21, 22, and consequently will also contribute to the maximum current which is available on the corresponding outputs. This represents a type of sensing and this kind of sensing (regulation resistors 217, 227) can be used to protect the switching elements. Nevertheless, the output current of the respective boost converter depends on the load connected to the output, and of course on the output voltage of the regulator (I = V/R).

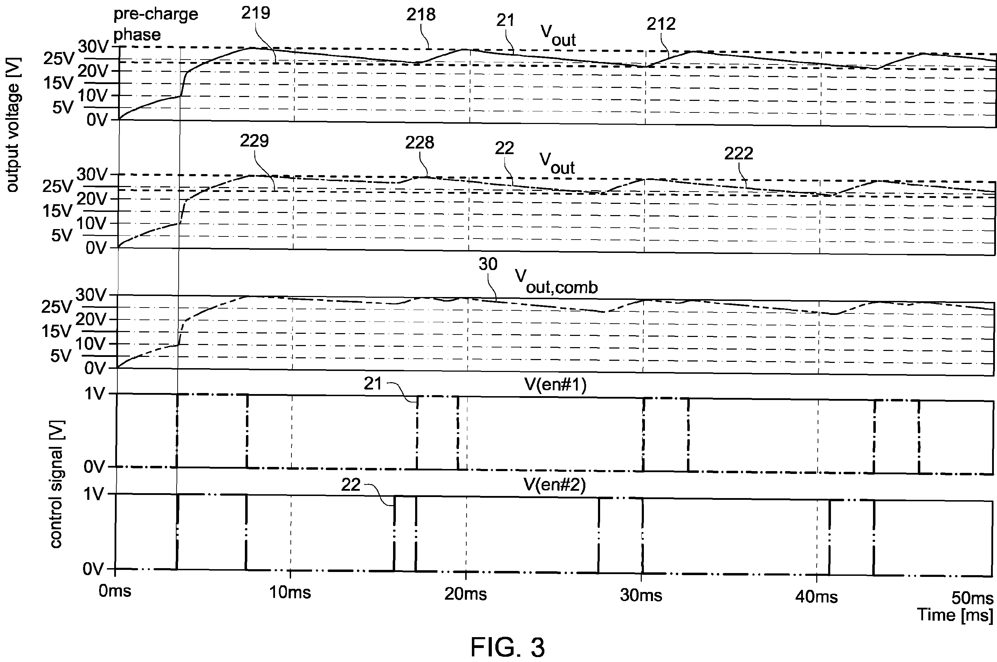

The battery management system 1 includes a first pre-charge path 61 configured for limiting an inrush current of the first boost converter 21 during a pre-charge phase and a second pre-charge path 62 configured for limiting an inrush current of the second boost converter 22 during the pre-charge phase. At the pre-charge phase the first switching element 51 and second switching element 52 may be non-conductive until the output voltage Vₒᵤₜ is close to V_{IN} (see FIG. 3). Each of the pre-charge paths 61, 62 includes a pre-charge resistor 611, 621 and a pre-charge switching element 612, 622, e. g. a transistor, for enabling and disabling the corresponding pre-charge path.

The control unit 40 is configured to control the first switching element 51 and the second switching element 52 such that the first switching element 51 and the second switching element 52 are disabling the corresponding boost converters 21, 22 after start of the pre-charge phase, and to control the pre-charge switching elements 612, 622 such that the pre-charge switching elements 612, 622 are enabling the pre-charge paths 61, 62, e. g. are in a conductive state, after start of the pre-charge phase, wherein the first pre-charge path 61 through its pre-charge resistor 611 and the second pre-charge path 62 through its pre-charge resistor 621 are closed. The control unit 40 is further configured to control the first switching element 51 and the second switching element 52 such that the first switching element 51 and the second switching element 52 are enabling the corresponding boost converters 21, 22, e. g. are in a conductive state, after end of the pre-charge phase, and to control the pre-charge switching elements 612, 622 such that the pre-charge switching elements 612, 622 are disabling the pre-charge paths 61, 62, e. g. are in a non-conductive state, after end of the pre-charge phase, wherein the first pre-charge path 61 through its pre-charge resistor 611 and the second pre-charge path 62 through its pre-charge resistor 621 are interrupted.

The control unit 40 includes a second decentralized logic 402 connected to the first and second switching elements 51, 52 and to the pre-charge paths 61, 62 and configured to manage the limiting of the inrush current of both boost converters 21, 22.

The battery management system 1 includes a first soft-start path 71 configured for mitigating an inrush current of the first boost converter 21 during a soft-start phase and a second soft-start path 72 configured for mitigating an inrush current of the second boost converter 22 during the soft-start phase. In other words, for example after finishing the pre-charge phase, a softer/shorter switching may be configured. Each of the soft-start paths 71, 72 includes a soft-start capacitor 711 and a soft-start switching element, e. g. a transistor, for enabling and disabling the corresponding soft-start path 71, 72.

The control unit 40 is configured to control the soft-start switching elements such that the soft-start switching elements are enabling the soft-start paths 71, 72, e. g. are in a conductive state, after start of the soft-start phase, wherein the first soft-start path 71 through its soft-start capacitor 711 and the second soft-start path 72 through its soft-start capacitor 721 are closed. The control unit 40 is further configured to control the soft-start switching elements such that the soft-start switching elements are disabling the soft-start paths 71, 72, e. g. are in a non-conductive state, after end of the soft-start phase, wherein the first soft-start path 71 through its soft-start capacitor 711 and the second soft-start 72 path through its soft-start capacitor 721 are interrupted.

The battery management system 1 includes a first current-limiting path 81 configured for limiting an output current of the first boost converter 21 during a run-time phase and a second current-limiting path 82 configured for limiting an output current of the second boost converter 22 during a run-time phase. Each of the current-limiting paths 81, 82 includes a current-limiting resistor 811, 821 and a current-limiting switching element. The control unit 40 is configured to control the current-limiting switching elements such that the current-limiting switching elements are enabling the current-limiting paths 81, 82, e. g. the first current-limiting path 81 through its current-limiting resistor 811 and the second current-limiting path 82 through its current-limiting resistor 821 are connected to the respective output 212, 222.

The control unit 40 includes a third decentralized logic 403 connected to the soft-start paths 71, 72 and to the current-limiting paths 81, 82 and configured to manage the mitigating of the inrush current of both boost converters 21, 22 and to manage the limiting of the output current of both boost converters 21, 22.

The control unit 40 is configured to disable the first boost converter 21 and/or the second boost converter 22 when an overcurrent event or short circuit event occurs. In other words, the battery management system 1 includes a dedicated control input for the first and/or second boost converter 21, 22, configured to disable the respective boost converter 21, 22 during an ignition process of the pyrofuse, thereby preventing voltage drops on the supply rail and ensuring stable operation of other system components.

The control unit 40 includes a fourth logic 404 connected to the switching elements 51, 52 and configured to manage the disabling of the boost converters 21, 22.

The logics 401, 402, 403, 404 described may be provided for each boost converter 21, 22 as a separate decentralized logic or may be provided as a centralized logic for both boost converters 21, 22. The first centralized logic 401 is for example provided for each boost converters 21, 22, wherein both logics 401 are connected to each other to control the interleaved operation.

The control unit 40 includes an AND-gate 405 connected to the first, second and fourth decentralized logic 401, 402, 404 receiving a first input for a signal based on the interleaved operation, a second input for a signal based on the first and second pre-charge paths 61, 62 and a third input for a signal based on the occurring of the overcurrent event and providing a control signal EN for the first and second switching elements 51, 52. The decentralized logics 401, 402, 404 operate independently while communicating with one another to coordinate the aforementioned tasks and ensure reliable system functionality.

FIG. 2 is a schematic overview illustrating a battery management system 1 according to an embodiment. Elements corresponding to components described in FIG. 1 are not explained again and the corresponding description in relation to FIG. 1 is to be applied to these. The combination of a first and a second boost converter 21, 22 with each other in connection with a pyrofuse 10 or parts of the pyrofuse 10 is shown here (squib of the pyrofuse). The boost converters 21, 22 may be, for example, the boost converters 21, 22 from Figure 1. For reasons of clarity, not all of the previous features are shown. The focus here is on the combination of the two boost converters 21, 22 with each other. The input 211, 221 of both boost converters 21, 22 is a common input that is connected to one energy source (not shown). In other words, the same input voltage is applied to their respective input 211, 221. It can be seen that they are combined to form a combined output 30 that is connected to an ignition switching element 11 of the pyrofuse 10. If a corresponding event occurs, the ignition switching element 11 is conductive and ignition of the pyrofuse 10 or its squib takes place.

The battery management system 1 further includes a combined analog-to-digital converter, ADC, 91 connected to the combined output 30 for determining the combined output voltage.

The battery management system 1 includes a combined diagnostic load 92, in the present case a combined diagnostic load resistor, connected in parallel with the boost converters 21, 22 at the combined output 30, and the control unit 40 is configured to determine a total capacitance of the boost converters 21, 22 based on a measured voltage decay of a voltage across the combined diagnostic load 92 and a known resistance value of the combined diagnostic load 92 during a discharging of both boost converters.

The combined analog-to-digital converter 91 is further connected to the combined diagnostic load to measure or for determining the voltage across the combined diagnostic load 92.

Each boost converter 21, 21 is connected to the combined diagnostic load 92 through a separate switching element 921, 922, e. g. a MOSFET switch or relay, and the control unit 40 is configured to open one of the separate switching elements 921, 922 to disconnect the corresponding boost converter 21, 22 from the combined diagnostic load 92, and the control unit 40 is further configured to determine the capacitance of the remaining connected boost converter 21, 22 based on a measured voltage decay across the combined diagnostic load 92 and the known resistance value of the combined diagnostic load 92 during a discharging of the remaining connected boost converter 21, 22.

FIG. 3 is a schematic diagram illustrating of an operation of battery management system according to an embodiment. The battery management system may be the battery management system 1 of FIGS. 1 and 2.

The control unit 40 is configured to control the first and second boost converters 21, 22 based on hysteresis during interleaved operation. In other words, the control unit 40 is configured to control the first and second boost converters 21, 22 based on hysteresis that maintains the output voltage at the output 212, 222 within a predefined range by activating the switching element 214 of the first boost converter 21, e. g. a transistor, or the switching element 224 of the second boost converter 22, e. g. a transistor, when the corresponding output voltage reaches or drops below a lower limit 219, 229, and deactivating the switching element 214 of the first boost converter 21 or the switching element 224 of the second boost converter 22 when the corresponding output voltage reaches or exceeds an upper limit 218, 228. In other words, the boost converters 21, 22 are activated when they fall below the lower limit 219, 229 or are deactivated when they reach or exceed the upper limit 218, 228.

The diagram shows, on the one hand, the output voltage curve of each of the two boost converters 21, 22 at their respective outputs 212, 222 and the combined output voltage V_{out,comb} at their combined output 30. Furthermore, the curve of the control signal EN#1, EN#2 or the control voltage V(en#1), V(en#2) of the first boost converter 21 and the second boost converter 22 is shown. This alternates between On (1 V) and Off (0 V). If the control signal is 1 V, the corresponding boost converter is active - if the control signal is 0 V, the corresponding boost converter is inactive. Initially there is a start-up phase, which includes a pre-charge phase. After reaching an upper limit 218, 228 of the two boost converters 21, 22, these are initially inactive. Subsequently, in the present embodiment, interleaved operation is started by the control unit 40 before a lower limit 219, 229 is reached, so that one of the two boost converters, initially the second boost converter 22 in the present case, is active. As soon as it reaches the upper limit 229, it is deactivated. The first boost converter 21 is then activated until it also reaches its upper limit 218, whereupon it is deactivated. In a subsequent phase, both boost converters 21 and 22 are inactive. The voltage of both is above their respective lower limit 219, 229. Only as soon as this lower limit 219, 229 is reached, in this case first by the second boost converter 22, it is activated again until it reaches its upper limit 228. Subsequently, the first boost converter 21, which has reached its lower limit 219, is activated again until it reaches its upper limit 218.

The lower limits 219, 229 are approximately 24 V and the upper limits 218, 228 are approximately 30 V. These limits form the hysteresis within which the target voltage lies, for example at around 27 V.

During interleaved operation the control unit 40 is configured to activate that one of the boost converters 21, 22 which has first reached or is first below a lower limit of the hysteresis. In the present embodiment the second boost converter 22 has first reached the lower limit 229 of the hysteresis. The control unit 40 is further configured to deactivate this one of the boost converters when this one of the boost converters has reached the upper limit 228 of the hysteresis. In the present embodiment the second boost converter 22 reaches the upper limit 229 of the hysteresis and gets deactivated. In other words, the hysteresis may also be used to switch between the two boost converters 21, 22 during interleaved operation. This means that once one of the two boost converters 21, 22 has reached its upper limit 218, 228, it can be deactivated and the other one of the two boost converters 21, 22 can be activated. The other one of the to boost converters 21, 22 may be activated when it reaches the lower limit 219, 229 or when it is below it in the moment the one of the two boost converters has reached the upper limit 218, 228 and is deactivated. When the other one of the boost converters 21, 22 is above the lower limit 219, 229 both boost converters are inactive. When the one of the boost converters 21, 22 reaches the lower limit 219, 229 before the other one reaches it then the one of the boost converters 21, 22 may be activated again. Once the other one of the two boost converters 21, 22 has also reached the upper limit 218, 228 after its activation, both boost converters 21, 22 may be inactive. As soon as one of the two boost converters 21, 22, for example the one of the two boost converters, in the present embodiment the second boost converter 22, has reached the lower limit 229, it is activated and operated until it reaches the upper limit 228. During this time, the other of the two boost converters 21, 22, in the present embodiment the first boost converter 21, is inactive due to the interleaved operation. Accordingly, this procedure is repeated during interleaved operation. In other words, the boost converters 21, 22 are operated with only one being active at a time. The boost converters 21, 22 are activated or deactivated depending on the lower and upper limits 219, 229, 218, 228. After each deactivation, it is determined whether one of the two is below the lower limit 219, 229 or reaches it, whereby the boost converter 21, 22 that first fulfills this condition after the previous deactivation is activated. This ensures that only one boost converter is active at any one time and that availability is always guaranteed thanks to this control concept, while at the same time reducing the demands on the system, such as the level of input currents.

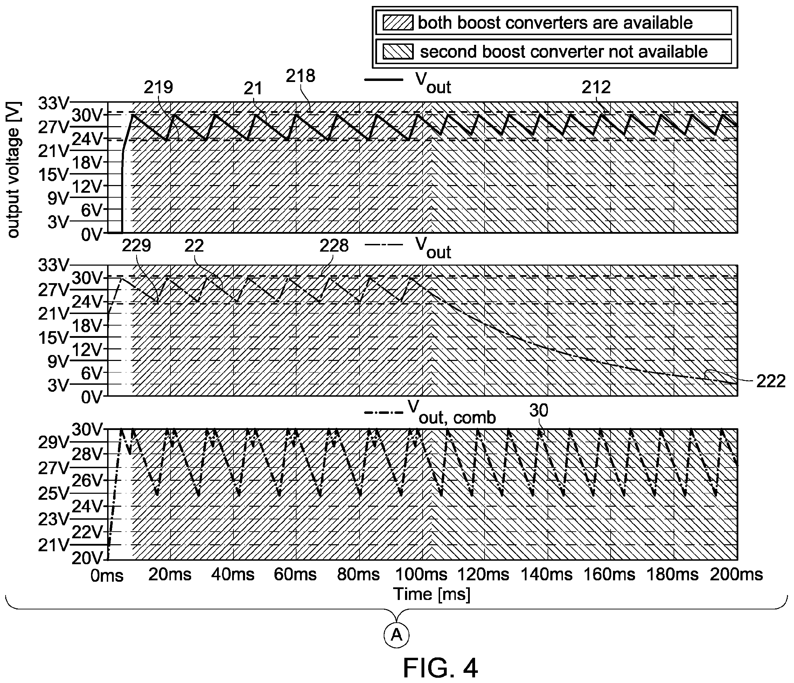

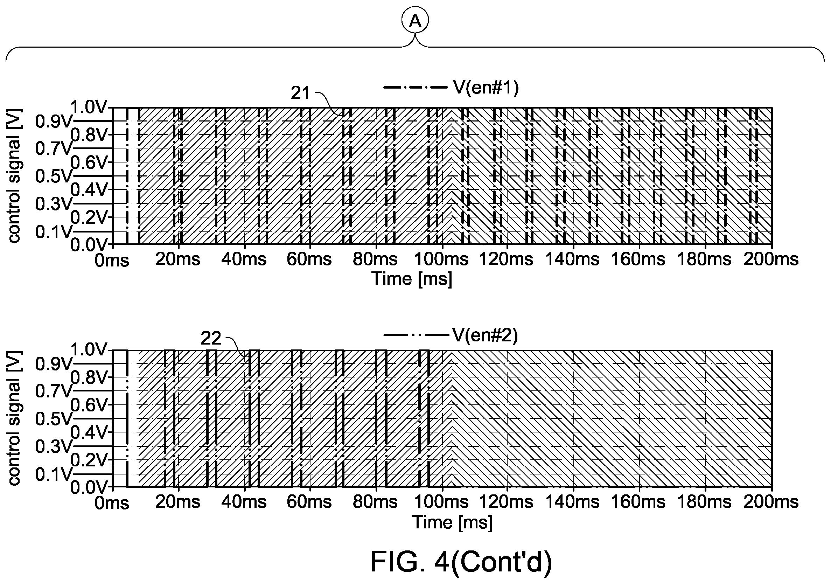

FIG. 4 is a schematic diagram illustrating an operation of battery management system according to an embodiment. The battery management system may be the battery management system 1 of FIG. 1 and FIG. 2. Elements corresponding to components described in FIG. 3 are not explained again and the corresponding description in relation to FIG. 3 is to be applied to these. As an example, the right-hand section shows that one of the two boost converters 21, 22, namely the second boost converter 22, is permanently inactive. As a result, the voltage at its output 222 is constantly decreasing. Its corresponding control signal is constant at 0 V. The effect of this behavior on the combined output voltage at output 30 is shown. This now exhibits a constant sawtooth pattern. In contrast, when both boost converters 21, 22 are active, the curve shows two local maxima in quick succession. From this deviation in characteristics between properly functioning boost converters 21, 22 and faulty boost converters 21, 22, it can be deduced from the combined output voltage that one of the boost converters 21, 22 is not available.

In other words, FIG 4 shows a graphical representation of the voltage and signal behavior in the battery management system 1 with two boost converters 21, 22. The plots are divided into two main phases: one where both boost converters 21, 22 are available (left area) and another where the second boost converter 22 is unavailable (right area).

The topmost graph represents the voltage across the charging capacitor 213 of the first boost converter 21. During the phase where both converters 21, 22 are available, their respective voltage exhibits a periodic ripple pattern, indicating active operation. This behavior remains stable for the first boost converter 21 even when the second boost converter 22 becomes unavailable.

The second graph shows the voltage across the charging capacitor 223 of the second boost converter 22. During the phase, where both converters 21, 22 are available, the voltage of the second boost converter 22 follows a similar ripple pattern as the first boost converter 21. However, when the second boost converter 22 becomes unavailable, its voltage begins to drop steadily, indicating it is no longer actively operating or charging.

The third graph represents the combined output voltage of the two boost converters 21, 22. During the phase, where both converters 21, 22 are available, the combined output voltage shows regular ripple behavior, with contributions from both converters 21, 22. After the second boost converter 22 becomes unavailable, the ripple pattern persists, but the combined output 30 reflects only the contribution of the first boost converter 21.

The bottom graph shows the enabling signals for the first boost converter 21 and for the second boost converter 22. During the phase, where both converters 21, 22 are available, both signals are active, indicating that both converters 21, 22 are operational. Once the second boost converter 22 becomes unavailable, its enabling signal is no longer active, while the signal for the first boost converter 21 remains active.

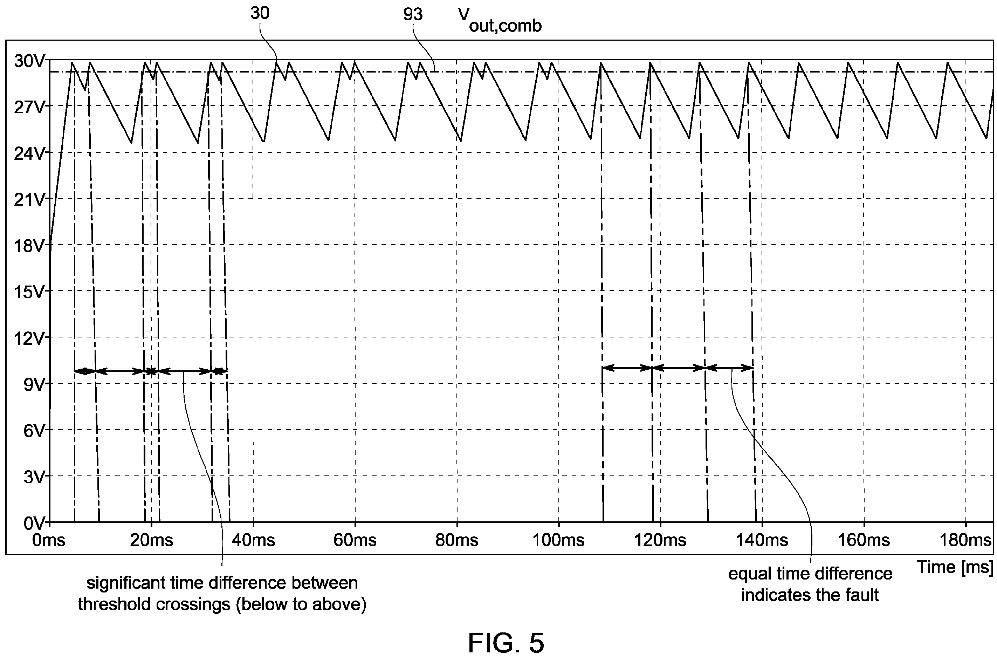

FIG. 5 is a schematic diagram illustrating an operation of battery management system according to an embodiment. The battery management system may be the battery management system 1 of FIG. 1 and FIG. 2. Elements corresponding to components described in FIG. 3 or FIG. 4 are not explained again and the corresponding description in relation to FIG. 3 or FIG. 4 is to be applied to these.

The control unit 40 is configured to detect that at least one of the boost converters 21, 22 is permanently in an inactive state based on a threshold value 93 of the determined combined output voltage. The threshold value is between an upper limit 218, 228 and a lower limit 219, 229 of the hysteresis. The control unit 40 is configured to detect that at least one of the boost converters 21 is permanently in an inactive state by monitoring a crossing of the combined output voltage of the threshold value 93, either from below to above or above to below, with distinct timing patterns depending on whether both boost converters 21, 22 are operating in interleaved mode or whether one boost converter 21, 22 is permanently inactive.

The described signal analysis may involve various techniques used to examine and process signals. The control unit 40 may include signal processing by means of software, e.g. executed in a microcontroller (MCU) for the detection.

Here it is clearly recognizable that in the phase in which both boost converters 21, 22 are available, a characteristic pattern for the time difference between the exceeding of the combined output voltage of the threshold value 93 from below to above occurs. This results in two discrete time differences that differ from each other and occur alternately. In the phase in which one of the boost converters 21, 22 is no longer available, this pattern changes. There are then constant time intervals for the crossing, so that it is clearly recognizable that one boost converter 21, 22 is no longer available.

In other words, FIG. 5 depicts the behavior of the combined output voltage of the battery management system 1 with boost converters 21, 22, highlighting the diagnostic approach for detecting faults based on threshold crossing patterns. The graph shows the periodic ripple of the combined output voltage as it fluctuates between peaks and troughs. The ripples cross a specified threshold voltage 93, which is used as a diagnostic indicator. In the left section of the graph, labeled as "significant time difference between threshold crossings (below to above)," the time intervals between consecutive threshold crossings are uneven. This behavior indicates that both boost converters 21, 22 are operational and contributing differently to the combined output ripple. In the right section of the graph, labeled as "equal time difference indicates the fault," the time intervals between consecutive threshold crossings become consistent. This change signifies that one of the boost converters 21, 22 has failed or is no longer contributing, resulting in a symmetric and predictable ripple pattern. The image demonstrates the diagnostic methodology. By analyzing the timing of threshold crossings, the control unit 40 can detect whether the system 1 is functioning correctly or if a fault has occurred in one of the boost converters 21, 22. The consistent ripple pattern in the fault state serves as a clear indication of the issue.

### Reference signs

- 1: battery management system
- 10: pyrofuse
- 11: ignition switching element
- 21: first boost converter
- 211: input
- 212: output
- 213: charging capacitor
- 214: switching element
- 215: inductor
- 216: diode
- 217: regulation resistor
- 218: upper limit
- 219: lower limit
- 22: second boost converter
- 221: input
- 222: output
- 223: charging capacitor
- 224: switching element
- 225: inductor
- 226: diode
- 227: regulation resistor
- 228: upper limit
- 229: lower limit
- 30: combined output
- 40: control unit
- 401: first decentralized logic
- 402: second decentralized logic
- 403: third decentralized logic
- 404: fourth decentralized logic
- 405: AND-Gate
- 51: first switching element
- 52: second switching element
- 61: first pre-charge path
- 611: pre-charge resistor
- 612: pre-charge switching element
- 62: second pre-charge path
- 621: pre-charge resistor
- 622: pre-charge switching element
- 71: first soft-start path
- 711: soft-start capacitor
- 72: second soft-start path
- 721: soft-start capacitor
- 81: first current-limiting path
- 811: current-limiting resistor
- 82: second-current-limiting path
- 821: current-limiting resistor
- 91: combined analog-to-digital converter
- 92: combined diagnostic load
- 921: separate switching element
- 922: separate switching element
- 93: threshold value

## Claims

1. A battery management system (1), comprising:
a pyrofuse (10) configured to open a power path of a battery pack;
a first boost converter (21) and a second boost converter (22), wherein the first boost converter (21) and the second boost converter (22) have a common input (211, 221) and different outputs (212, 222) connected at an combined output (30), and are each configured to store energy in a charging capacitor (213, 223) of the respective boost converter (21, 22) and to provide the stored energy to fire the pyrofuse (10) when an overcurrent event or short circuit event occurs;
and a control unit (40), wherein the control unit (40) is configured to determine an availability of both boost converters (21, 22) based on a determined combined output voltage of the combined output (30) when the boost converters (21, 22) are at least temporarily operated in interleaved operation.

2. The battery management system (1) as claimed in claim 1, wherein the control unit (40) is configured to determine the availability of both boost converters (21, 22) based on a characteristic waveform of the determined combined output voltage.

3. The battery management system (1) as claimed in claim 1 or 2, wherein the control unit (40) is configured to detect that at least one of the boost converters (21, 22) is permanently in an inactive state based on a threshold value (93) of the determined combined output voltage.

4. The battery management system (1) as claimed in claim 3, wherein the control unit (40) is configured to detect that at least one of the boost converters (21, 22) is permanently in an inactive state by monitoring a crossing of the determined combined output voltage of the threshold value (93), either from below to above or above to below, with distinct timing patterns depending on whether both boost converters (21, 22) are operating in interleaved mode or whether one boost converter (21, 22) is permanently inactive.

5. The battery management system (1) as claimed in any one of the preceding claims, wherein the battery management system (1) further comprises a combined analog-to-digital converter (91) connected to the combined output (30) for determining the combined output voltage.

6. The battery management system (1) as claimed in any one of claims 1 to 5, wherein the battery management system (1) further comprises a combined diagnostic load (92) connected in parallel with the boost converters (21, 22) at the combined output (30), and wherein the control unit (40) is configured to determine a total capacitance of the boost converters (21, 22) based on a measured voltage decay of a voltage across the combined diagnostic load (92) and a known resistance value of the combined diagnostic load (92) during a respective discharging of both boost converters (21).

7. The battery management system (1) as claimed in claim 6, wherein the control unit (40) is configured to determine the total capacitance of the boost converters (21, 22) during a run-time phase of the boost converters (21, 22).

8. The battery management system (1) as claimed in claim 6 or 7, wherein the control unit (40) is configured to determine the total capacitance before contactors of the battery management system or of the battery pack are closed.

9. The battery management system (1) as claimed in any one of claims 6 to 8, wherein each boost converter (21, 22) is connected to the combined diagnostic load (92) through a separate switching element (921, 922), and wherein the control unit (40) is configured to open one of the separate switching elements (921, 922) to disconnect the corresponding boost converter (21, 22) from the combined diagnostic load (92), and wherein the control unit (40) is further configured to determine the capacitance of the remaining connected boost converter (21, 22) based on a measured voltage decay across the combined diagnostic load (92) and the known resistance value of the combined diagnostic load (92) during a discharging of the remaining connected boost converter (21, 22).

10. A method for diagnosing a battery management system (1) for firing a pyrofuse (10), wherein the method comprises the steps of:
a) providing a battery management system (1) as defined in anyone of the preceding claims 1 to 9;
b) operating the boost converters (21, 22) at least temporarily in interleaved operation;
c) determining a combined output voltage of the combined output (30) during interleaved operation;
d) determining an availability of both boost converters (21, 22) based on the determined combined output voltage of the combined output (30).

11. The method as claimed in claim 10, wherein step d) comprises the step of:
d1) detecting that at least one of the boost converters (21, 22) is permanently in an inactive state based on a threshold value (93) of the determined combined output voltage.

12. The method as claimed in claim 11, wherein step d1) comprises monitoring a crossing of the combined output voltage of the threshold value (93), either from below to above or above to below, with distinct timing patterns depending on whether both boost converters (21, 22) are operating in interleaved mode or whether one boost converter (21, 22) is permanently inactive.

13. The method as claimed in any one of claims 10 to 12, wherein the method further comprises the step of:
e) determining a total capacitance of the boost converters (21, 22) based on a measured voltage decay of a voltage across a combined diagnostic load (92) connected in parallel with the boost converters (21, 22) at the combined output (30) and a known resistance value of the combined diagnostic load (92) during a respective discharging of both boost converters (21, 22).

14. A battery system, comprising:
the battery management system (1) as claimed in any one of the preceding claims; and
the battery pack including a housing and at least one battery cell accommodated within the housing.

15. An electric vehicle comprising the battery system as claimed in claim 14.
